# EUROPEAN PATENT APPLICATION

(11) **EP 3 471 525 A1**
(43) Date of publication of application: **17.04.2019**
(21) Application number: 18781943.8
(22) Date of filing: 11.05.2018
(51) Int. Cl.: H05K 9/00, G01R 1/18

(54) **ELECTROMAGNETIC SHIELD STRUCTURE AND ELECTRONIC DEVICE HAVING SAME**

(30) Priority: 03.08.2017 CN 201710657156
(71) Applicant: Autel Robotics Co., Ltd., Shenzhen, Guangdong 518055 (CN)
(72) Inventor: LIANG, Zhiying, Shenzhen Guangdong 518055 (CN)
(74) Representative: Gulde & Partner
(86) International application number: PCT/CN2018/086597
(87) International publication number: WO 2019/024567

(57) **Abstract**

The present application relates to the field of electromagnetic interference processing technologies, and provides an electromagnetic shielding structure. The electromagnetic shielding structure includes a first shielding member and a second shielding member. The first shielding member includes a first bottom wall and a first side wall extending from an outer edge of the first bottom wall, the first bottom wall and the first side wall of the first shielding member form a cavity, the first shielding member comprises a first cavity partition wall, and the first cavity partition wall partitions the first cavity into at least two first accommodating cavities. The second shielding member is detachably mounted on the first shielding member, so as to seal the first cavity of the first shielding member. The first shielding member and the second shielding member jointly accommodate the circuit board between the first shielding member and the second shielding member, to perform electromagnetic shielding for the circuit board. The electromagnetic shielding structure may protect the circuit board from interference from an external signal, thereby improving a shielding effect.

## Description

The present application claims priority to Chinese Patent Application No. 201710657156.0, filed with the Chinese Patent Office on August 3, 2017, and entitled "ELECTROMAGNETIC SHIELDING STRUCTURE AND ELECTRONIC DEVICE HAVING THE SAME", which is incorporated by reference in its entirety.

### Technical Field

The present application relates to the field of electromagnetic interference processing technologies, and in particular, to an electromagnetic shielding structure applied to an electronic device such as a circuit board.

### Related Art

With the rapid development of electronic technologies, the use of new functions and new parts in electronic devices is also continuously increased. As electronic devices are developed toward a higher processing capacity and a wider application field, circuits in a circuit board in an electronic device also become more complex and denser, where, however, electric fields of all lines interfere with each other, resulting in electromagnetic interference between the circuits in the circuit board. In addition, an external signal may also interfere with the electronic device. Therefore, in the field of electronic devices, prevention of electromagnetic interference becomes an urgent problem to be resolved currently.

### SUMMARY

To resolve the foregoing technical problems, embodiments of the present application provide an electromagnetic shielding structure with good shielding performance and an electronic device having the electromagnetic shielding structure.

To resolve the foregoing technical problems, the embodiments of the present application provide the following technical solutions:
An electromagnetic shielding structure is applied to a circuit board. The electromagnetic shielding structure includes a first shielding member and a second shielding member. The first shielding member includes a first bottom wall and a first side wall extending from an outer edge of the first bottom wall. The first bottom wall and the first side wall of the first shielding member form a first cavity. The first shielding member includes a first cavity partition wall, and the first cavity partition wall partitions the first cavity into at least two first accommodating cavities. The second shielding member is detachably mounted on the first shielding member, so as to seal the first cavity of the first shielding member. The first shielding member and the second shielding member jointly accommodate the circuit board between the first shielding member and the second shielding member, to perform electromagnetic shielding for the circuit board.

In some embodiments, one end of the first cavity partition wall is in contact with the circuit board or is connected to the circuit board.

In some embodiments, the first cavity partition wall further includes a first sealing rubber strip disposed on an end face of the first cavity partition wall, wherein the first sealing rubber strip is in contact with the circuit board or is connected to the circuit board, so as to seal the at least two first accommodating cavities.

In some embodiments, electronic components are disposed on the circuit board, the circuit board includes a first surface and second surface that are oppositely disposed, and the electronic components are all disposed on the first surface; and the second shielding member is of a flat-plate shape, the first surface faces toward the first cavity of the first shielding member, the second surface faces toward the second shielding member, and the entire surface of the second surface is in contact with the second shielding member.

In some embodiments, a first heat dissipating portion is disposed on the first shielding member, wherein the electronic components disposed on the first surface perform heat dissipation by using the first heat dissipating portion.

In some embodiments, the first heat dissipating portion is in contact with or is connected to the electronic components disposed on the first surface.

In some embodiments, a thermally conductive member is disposed between the first heat dissipating portion and the electronic components disposed on the first surface, and the thermally conductive member is in contact with or is connected to the electronic components disposed on the first surface, so that heat generated by the electronic components disposed on the first surface is transferred to the first heat dissipating portion by using the thermally conductive member.

In some embodiments, the thermally conductive member is thermally conductive adhesive or thermally conductive foam.

In some embodiments, electronic components are disposed on the circuit board, the circuit board includes a first surface and a second surface that are oppositely disposed, and the electronic components are separately disposed on the first surface and the second surface; the second shielding member includes a second bottom wall and a second side wall extending from an outer edge of the second bottom wall, the second bottom wall and the second side wall form a second cavity, the first surface faces toward the first cavity, and the second surface faces toward the second cavity.

In some embodiments, the second shielding member includes a second cavity partition wall, wherein the second cavity partition wall partitions the second cavity into at least two second accommodating cavities, wherein one end of the second cavity partition wall is in contact with the second surface or is connected to the second surface.

In some embodiments, the second cavity partition wall further includes a second sealing rubber strip disposed on an end face of the second cavity partition wall, wherein the second sealing rubber strip is in contact with the second surface or is connected to the second surface, so as to seal the at least two second accommodating cavities.

In some embodiments, a first heat dissipating portion is disposed on the first shielding member, wherein the electronic components disposed on the first surface perform heat dissipation by using the first heat dissipating portion; and a second heat dissipating portion is disposed on the second shielding member, wherein the electronic components disposed on the second surface perform heat dissipation by using the second heat dissipating portion.

In some embodiments, the first heat dissipating portion is in contact with or is connected to the electronic components disposed on the first surface, and/or the second heat dissipating portion is in contact with or is connected to the electronic components disposed on the second surface.

In some embodiments, a thermally conductive member is disposed between the first heat dissipating portion and the electronic components, wherein the thermally conductive member is in contact with or is connected to the electronic components disposed on the first surface, so that heat generated by the electronic components disposed on the first surface is transferred to the first heat dissipating portion by using the thermally conductive member.

In some embodiments, a thermally conductive member is disposed between the second heat dissipating portion and the electronic components, wherein the thermally conductive member is in contact with or is connected to the electronic components disposed on the second surface, so that heat generated by the electronic components disposed on the second surface is transferred to the second heat dissipating portion by using the thermally conductive member.

In some embodiments, the thermally conductive member is thermally conductive adhesive or thermally conductive foam.

In some embodiments, the circuit board includes two circuit boards that are disposed in parallel, wherein the first surface is located on one of the circuit boards, and the second surface is located on the other of the circuit boards.

In some embodiments, the first shielding member and/or the second shielding member are/is provided with heat dissipating strips/a heat dissipating strip.

In some embodiments, the first shielding member and the second shielding member are connected in a snap-fit manner.

In some embodiments, one of the first shielding member and the second shielding member includes a protrusion, and the other includes a gap, wherein the protrusion is inserted in the gap.

In some embodiments, an inner wall of the first shielding member or the second shielding member is provided with a groove, and the circuit board is inserted in the groove to be fixed inside the electromagnetic shielding structure.

In some embodiments, the circuit board is provided with a plurality of first through holes, and the first shielding member and/or the second shielding member are/is provided with a plurality of second through holes whose position distribution and number are in one-to-one correspondence with those of the first through holes, and wherein the first through holes and the second through holes are configured to mount the circuit board in the electromagnetic shielding structure.

In some embodiments, the first shielding member and/or the second shielding member are/is integrally molded.

To resolve the foregoing technical problems, the embodiments of the present application further provide the following technical solution:
An electronic device is provided, including a circuit board and the electromagnetic shielding structure as described above, where the first shielding member and the second shielding member jointly accommodate the circuit board between the first shielding member and the second shielding member.

Compared with the prior art, the first shielding member and the second shielding member jointly accommodate the circuit board between the first shielding member and the second shielding member, so that the circuit board can be protected from electromagnetic interference from an external signal, and electromagnetic radiation of the circuit board can also be limited from exceeding the electromagnetic shielding structure, thereby improving an electromagnetic shielding effect.

In addition, the first shielding member includes at least two first accommodating cavities independent of each other, and electronic components of the circuit board may be separately accommodated in the first accommodating cavities independent of each other, so that electromagnetic interference generated between the electronic components of the circuit board can be reduced.

### BRIEF DESCRIPTION OF THE DRAWINGS

One or more embodiments are described as examples by using figures in the accompanying drawings corresponding thereto, and the examples do not constitute a limitation to embodiments. Elements having the same reference numerals in the accompanying drawings represent similar elements. The figures in the accompanying drawings do not constitute a proportion limitation unless otherwise noted.
FIG. 1 is a three-dimensional diagram of an electromagnetic shielding structure according to an embodiment of the present application;
FIG. 2 is a cross-sectional view of the electromagnetic shielding structure shown in FIG. 1;
FIG. 3 is an exploded view of the electromagnetic shielding structure shown in FIG. 1;
FIG. 4 is an exploded view of the electromagnetic shielding structure shown in FIG. 1 from another angle;
FIG. 5 is a three-dimensional diagram of an electromagnetic shielding structure according to another embodiment of the present application;
FIG. 6 is a cross-sectional view of the electromagnetic shielding structure shown in FIG. 5;
FIG. 7 is an exploded view of the electromagnetic shielding structure shown in FIG. 5;
FIG. 8 is an exploded view of the electromagnetic shielding structure shown in FIG. 5 from another angle; and
FIG. 9 is a locally enlarged diagram of a junction A between a first shielding member and a second shielding member of the electromagnetic shielding structure shown in FIG. 6.

### DETAILED DESCRIPTION

For ease of understanding the present application, the present application is described in detail below with reference to the accompanying drawings and specific implementations. It should be noted that when an element is expressed as "being fixed on" another element, the element may be directly on the another element, or there may be one or more elements between the element and the another element. When an element is expressed as "being connected to" another element, the element may be directly connected to the another element, or there may be one or more elements between the element and the another element. The terms "vertical", "horizontal", "left", "right", "internal", "external" and similar expressions used in this specification are merely for a purpose of description.

Unless otherwise defined, all technical and scientific terms used in this specification have the same meanings as common understanding of persons skilled in the art of the present application. The terms used in this specification of the present application are only for a purpose of describing specific implementations instead of limiting the present application. The term "and/or" used in this specification includes any or all combinations of one or more associated projects that are listed.

In addition, technical features involved in the different embodiments of the present application described below may be combined with each other provided that there is no conflict.

The embodiments of the present application are further described with reference to the accompanying drawings.

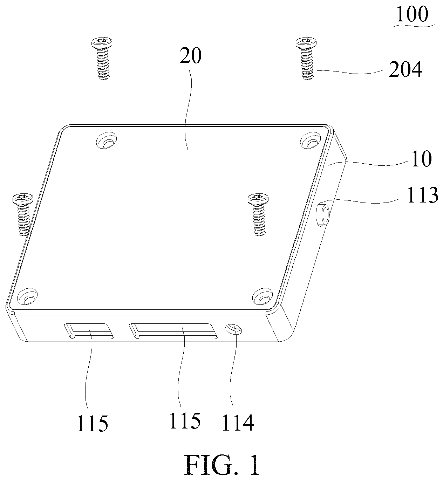

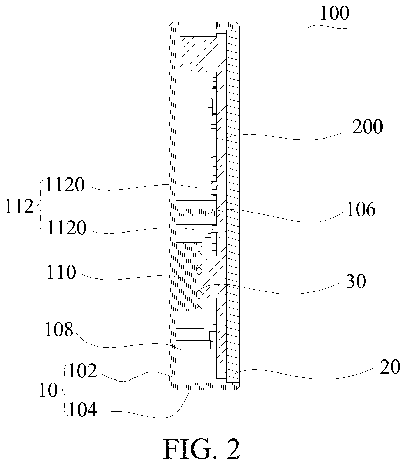

Referring to FIG. 1 and FIG. 2, an embodiment of the present application provides an electromagnetic shielding structure 100, configured to shield a circuit board 200 from electromagnetic interference and to perform heat dissipation. The electromagnetic shielding structure 100 includes a first shielding member 10 and a second shielding member 20. The first shielding member 10 and the second shielding member 20 jointly accommodate and seal the circuit board 200 between the first shielding member 10 and the second shielding member 20.

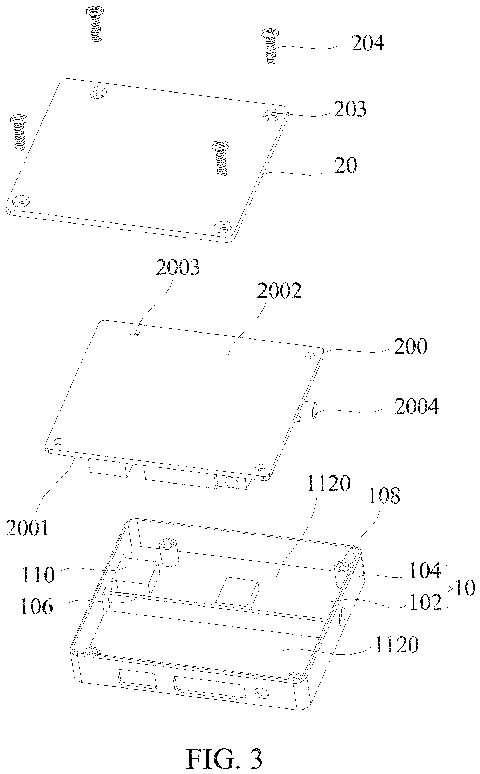

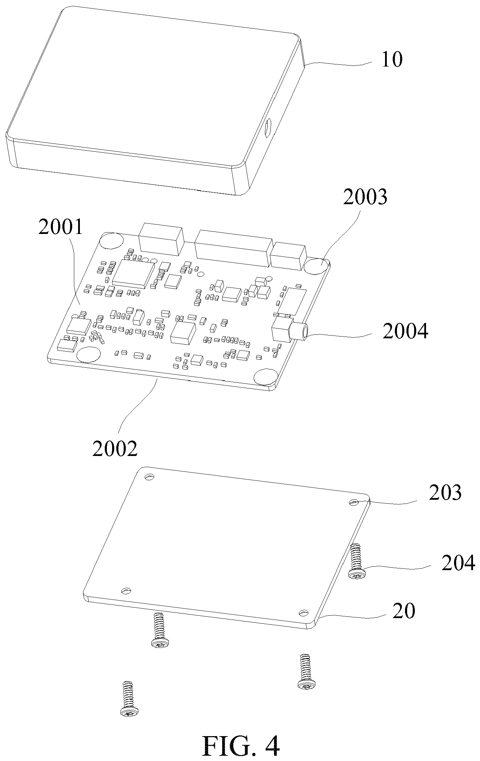

Referring to FIG. 3 and FIG. 4 together, the circuit board 200 includes a first surface 2001 and a second surface 2002 that are oppositely disposed. For convenience of mounting the circuit board 200 inside the electromagnetic shielding structure 100, the circuit board 200 is provided with a plurality of first through holes 2003. The through holes 2003 run through the first surface 2001 and the second surface 2002. A number of the first through holes 2003 may be determined according to an actual requirement, and may be, for example, 4, 6, or 8. The circuit board 200 further includes an antenna interface 2004. In this embodiment, the circuit board 200 is a single-sided circuit board. That is, all electronic components disposed on the circuit board 200 are disposed on only the first surface 2001 of the circuit board 200, and no electronic part or component is disposed on the second surface 2002 of the circuit board 200. It may be understood that a number of the circuit boards 200 is not limited to one and may be two or more. A plurality of circuit boards are accommodated together in the electromagnetic shielding structure 100. Preferably, the plurality of circuit boards are disposed in parallel. For example, when the number of the circuit boards is 2, the foregoing first surface 2001 may be located on one of the circuit boards, and the foregoing second surface 2002 may be located on the other of the circuit boards.

The first shielding member 10 is a case, and is approximately a hollow and cuboid structure. It may be understood that in some other embodiments, the first shielding member 10 may alternatively be set to another shape as required, for example, a cube. The first shielding member 10 may be formed by machining metal material, such as aluminum, copper and stainless steel, or other suitable material.

The first shielding member 10 accommodates the circuit board 200. Specifically, the first shielding member 10 includes a first bottom wall 102, a first side wall 104, a first cavity partition wall 106, a protruding column 108 and a first heat dissipating portion 110. The first side wall 104 extends from an outer edge of the first bottom wall 102. The first bottom wall 102 and the first side wall 104 form a first cavity 112. The first cavity partition wall 106 is connected to the first bottom wall 102 and the first side wall 104. The first cavity partition wall 106 partitions the first cavity 112 into at least two first accommodating cavities 1120 independent of each other. One end of the first cavity partition wall 106 is in contact with the circuit board 200 or is connected to the circuit board 200. The circuit board 200 is accommodated in the first cavity 112. The first surface 2001 of the circuit board 200 faces toward the first cavity 112 of the first shielding member 10. The electronic components of the circuit board 200 are separately disposed inside the at least two first accommodating cavities 1120, to shield circuits of the circuit board 200 from electromagnetic interference between the circuits. In some implementations, the first cavity partition wall 106 further includes a sealing rubber strip disposed on an end face of the first cavity partition wall 106. After the electromagnetic shielding structure 100 is mounted, the sealing rubber strip is in contact with or is connected to the circuit board 200, to seal the at least two first accommodating cavities 1120. Specifically, the sealing rubber strip may contain a metal substance, so that the sealing rubber is electrically connected to the first cavity partition wall 106, and the at least two first accommodating cavities 1120 partitioned by the first cavity partition wall 106 can better shield the circuit board 200.

Both the protruding column 108 and the first heat dissipating portion 110 extend from the first bottom wall 102, and are located inside the first accommodating cavities 1120.

Position distribution and a number of the protruding columns 108 are in one-to-one correspondence with the first through holes 2003 of the circuit board 200. For example, if the number of the first through holes 2003 of the circuit board 200 is 4, the number of the protruding columns 108 is also 4. Moreover, each of the protruding columns 108 has a screw hole.

The first heat dissipating portion 110 is in contact with or is connected to the electronic components on the circuit board 200. Specifically, the first heat dissipating portion 110 is in contact with or is connected to the electronic components disposed on the first surface 2001, to perform heat dissipation for the electronic components. Heat generated by the electronic components disposed on the circuit board 200 is transferred to the whole first shielding member 10 by using the first heat dissipating portion 110, and then the heat is dissipated by using the first shielding member 10. The first heat dissipating portion 110 may be, in a face-to-face manner, in direct contact with or be connected to the electronic components generating a relatively large amount of heat on the circuit board 200, to conveniently perform heat dissipation effectively and rapidly.

It may be understood that in some other embodiments, the first cavity partition wall 106 may be omitted, the at least two first accommodating cavities 1120 may be partitioned by using the first heat dissipating portion 110, and an end face of the first heat dissipating portion 110 is in contact with or is connected to the first surface 2001 of the circuit board 200.

The first shielding member 10 is integrally molded. Specifically, the first bottom wall 102, the first side wall 104 and the first cavity partition wall 106 are an integrated structure. The first bottom wall 102, the first side wall 104 and the first cavity partition wall 106 may be set to the integrated structure in any suitable manner such as integrated casting, stamping, or another suitable manner. To further ensure sealing, one end of the first cavity partition wall 106 is in contact with the circuit board 200.

It may be understood that in some other embodiments, the first cavity partition wall 106 and the first bottom wall 102 and the first side wall 104 may alternatively be separate structures. The first cavity partition wall 106 may be mounted on the first bottom wall 102 and the first side wall 104. For example, the first cavity partition wall 106 is welded on the first bottom wall 102 and the first side wall 104. In addition, to ensure sealing, the first cavity partition wall 106 is snugly mounted on the first bottom wall 102 and the first side wall 104.

The second shielding member 20 is of a flat-plate shape. The second surface 2002 of the circuit board 200 faces toward the second shielding member 20. To ensure a heat dissipation effect, the second shielding member 20 is in contact with the second surface 2002, and the entire surface of the second surface 2002 is in contact with the second shielding member 20. The second shielding member 20 is approximately of a rectangular shape. In some embodiments, the second shielding member 20 may alternatively be set to another shape, such as a square, as required. The second shielding member 20 is detachably mounted on the first shielding member 10, to seal the first cavity 112 of the first shielding member 10.

In some embodiments, to fit the first shielding member 10 to form a seal structure, the second shielding member 20 has a cross-sectional area approximately the same as that of the first shielding member 10 at a junction between the second shielding member 20 and the first shielding member 10. The second shielding member 20 may tightly fit an opening of the first shielding member 10 in a snap-fit manner, so that the second shielding member 20 and a frame of the first shielding member 10 are tightly closed up. The second shielding member 20 may be detachably mounted on the first shielding member 10 by using a screw and a thread or in another suitable manner. Moreover, to more effectively dissipate heat generated by the circuit board 200 during working, the second shielding member 20 may be formed by machining any material with good thermal conductivity, for example, metal material, such as aluminum alloy or copper alloy, or other suitable material with good thermal conductivity.

The second shielding member 20 is provided with a plurality of second through holes 203. To ensure that the second shielding member 20 can be mounted on the first shielding member 10, position distribution and the number of the protruding columns 108 of the first shielding member 10, the position distribution and the number of the second through holes 203 of the second shielding member 20, and the position distribution and the number of the first through holes 2003 of the circuit board 200 are in one-to-one correspondence. The first through holes 2003 and the second through holes 203 are configured to mount the circuit board 200 in the electromagnetic shielding structure 100. In another implementation, the plurality of second through holes 203 may be formed on the first shielding member 10, or the second through holes 203 may be formed on both the first shielding member 10 and the second shielding member 20.

The electromagnetic shielding structure 100 includes a plurality of screws 204. When the electromagnetic shielding structure 100 is assembled, the screws 204 sequentially pass through the second through holes 203 and the first through holes 2003, and are fixed into the thread holes of the protruding columns 108, to fix the first shielding member 10, the circuit board 200 and the second shielding member 20 together. Moreover, to ensure sealing, the second shielding member 20 tightly covers the opening of the first shielding member 10.

It may be understood that in some other embodiments, the first shielding member 10 and the second shielding member 20 may alternatively be connected in any other suitable manner, for example, snap-fit or clipping.

It may be understood that in some embodiments, an inner wall of the first shielding member 10 or the second shielding member 20 is provided with a groove, and the circuit board 200a is inserted in the groove to be fixed inside the electromagnetic shielding structure 300.

In some embodiments, to perform heat dissipation more effectively, heat dissipating strips may be disposed on both the first shielding member 10 and the second shielding member 20, to increase an amount of dissipated heat.

In some embodiments, referring to FIG. 2 again, the electromagnetic shielding structure 100 may further include a thermally conductive member 30. The thermally conductive member 30 is disposed between the first heat dissipating portion 110 and the electronic components disposed on the first surface 2001 of the circuit board 200. The thermally conductive member 30 is in contact with or is connected to the electronic components disposed on the first surface 2001, so that heat generated by the electronic components disposed on the first surface 2001 is transferred to the first heat dissipating portion 110 by using the thermally conductive member 30, thereby facilitating heat dissipation. In addition to dissipating heat generated by the circuit board 200, the thermally conductive member 30 may further tightly bond the first shielding member 10 and the circuit board 200 together. The thermally conductive member 30 may be thermally conductive adhesive or thermally conductive foam. The thermally conductive member 30 may include macromolecular thermally-conductive material or other suitable material such as silica gel and rubber.

Referring to FIG. 1 again, the first shielding member 10 further includes an antenna interface hole 113, an adjustment hole 114, and a data interface 115. The antenna interface 2004 of the circuit board 200 protrudes from the antenna interface hole 113, to facilitate connecting to an antenna in a plugged manner. The adjustment hole 114 is configured to adjust a resistor, a digital switch, and the like. The data interface 115 is configured to connect to a data line in a plugged manner.

In the electromagnetic shielding structure 100 provided in this embodiment of the present application, the second shielding member 20 is mounted on the first shielding member 10 in a sealed manner, to form a sealed space. The circuit board 200 is accommodated inside the sealed space, so that not only the circuit board 200 can be protected from interference from an external signal, but also internal electromagnetic radiation of the circuit board 20 can be limited from exceeding the electromagnetic shielding structure 100, thereby improving a shielding effect. In addition, heat generated by the circuit board 200 can also be effectively dissipated by using the first shielding member 10 and the second shielding member 20, to implement heat dissipation rapidly.

In addition, the first shielding member 10 includes the at least two first accommodating cavities 1120 independent of each other, and the electronic components of the circuit board 200 may be separately accommodated in first accommodating cavities 1120 independent of each other, so that electromagnetic interference generated between the electronic components of the circuit board 200 may be reduced.

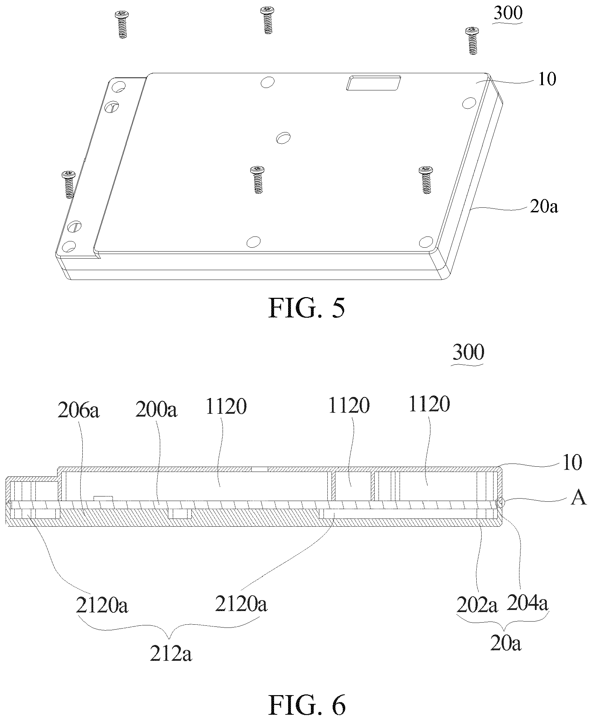

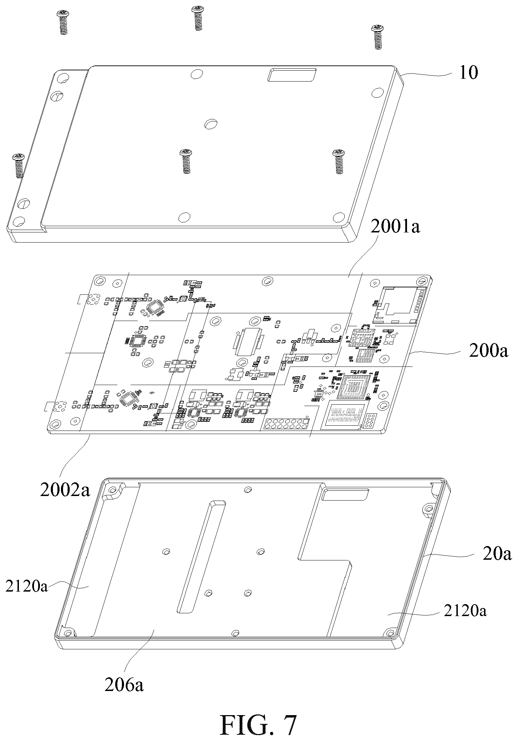

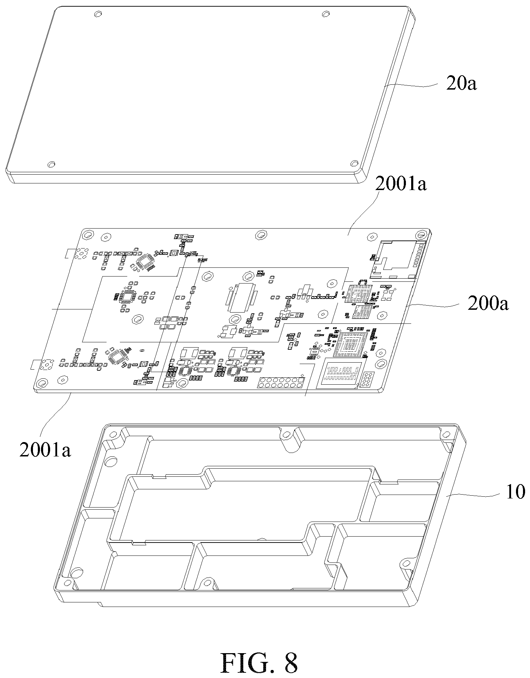

It should be noted that persons skilled in the art should understand that in some embodiments, if a circuit board is a dual-sided circuit board. That is, two opposite surfaces of the circuit board each are provided with electronic components. A second shielding member may become a structure similar to a first shielding member. An electromagnetic shielding structure configured to mount the dual-sided circuit board is further described below with reference to FIG. 5 to FIG. 9.

Referring to FIG. 5 to FIG. 8, FIG. 5 to FIG. 8 show an electromagnetic shielding structure 300 provided in another embodiment of the present application. The electromagnetic shielding structure 300 is approximately similar to the electromagnetic shielding structure 100 provided in the foregoing embodiment. A difference between the electromagnetic shielding structure 300 and the electromagnetic shielding structure 100 is that a structure of a second shielding member 20a of the electromagnetic shielding structure 300 is similar to that of the first shielding member 10, and the second shielding member 20a is a case, including a second bottom wall 202a, a second side wall 204a extending from an outer edge of the second bottom wall 202a, and a second heat dissipating portion 206a. The second bottom wall 202a and the second side wall 204a form a second cavity 212a.

The first shielding member 10 and the second shielding member 20a jointly accommodate and seal a circuit board 200a between the first shielding member 10 and the second shielding member 20a. A first surface 2001a of the circuit board 200a faces toward a first cavity 112 of the first shielding member 10. A second surface 2002a of the circuit board 200a faces toward the second cavity 212a of the second shielding member 20a. The electromagnetic shielding structure 300 may be configured to shield the circuit board 200a from electromagnetic interference and to perform heat dissipation.

The circuit board 200a is a dual-sided circuit board. That is, the first surface 2001a and the second surface 2002a of the circuit board 200a each are provided with electronic components. It may be understood that a number of the circuit boards 200a is not limited to one and may be two or more. A plurality of circuit boards are accommodated together in the electromagnetic shielding structure 300. Preferably, the plurality of circuit boards are disposed in parallel. For example, when the number of the circuit boards is 2, the foregoing first surface 2001a may be located on one of the circuit boards, and the foregoing second surface 2002a may be located on the other of the circuit boards.

In some embodiments, the second shielding member 20a further includes a second cavity partition wall, the second cavity partition wall partitions the second cavity 212a into at least two second accommodating cavities 2120a, and one end of the second cavity partition wall is in contact with the second surface 2002a or is connected to the second surface 2002. In some implementations, the second cavity partition wall further includes a sealing rubber strip disposed on an end face of the second cavity partition wall. After the electromagnetic shielding structure 300 is mounted, the sealing rubber strip is in contact with or is connected to the second surface 2002a of the circuit board 200a, to seal the at least two second accommodating cavities 2120a. Specifically, the sealing rubber strip may contain a metal substance, so that the sealing rubber is electrically connected to the second cavity partition wall, and the at least two second accommodating cavities 2120a partitioned by the second cavity partition wall can better shield the circuit board 200a.

The first accommodating cavities 1120 of the first shielding member 10 and the first surface 2001a of the circuit board 200a are located on one side of the circuit board 200a. The first accommodating cavities 1120 of the first shielding member 10 are configured to accommodate the electronic components on the first surface 2001a. Similarly, the second accommodating cavities 2120a of the second shielding member 20a and the second surface 2002a of the circuit board 200a are located on the other side of the circuit board 200a. The second accommodating cavities 2120a of the second shielding member 20a are configured to accommodate the electronic components on the second surface 2002a.

The electronic components disposed on the first surface 2001a of the circuit board 200a perform heat dissipation by using the first heat dissipating portion 110 on the first shielding member 10. The electronic components disposed on the second surface 2002a of the circuit board 200a perform heat dissipation by using the second heat dissipating portion 206a on the second shielding member 20a.

It may be understood that in some embodiments, the electromagnetic shielding structure 300 may include the thermally conductive member 30 in the foregoing embodiment. The thermally conductive member 30 may be disposed between the first heat dissipating portion 110 and the electronic components on the first surface 2001a. The thermally conductive member 30 is in contact with or is connected to the electronic components disposed on the first surface 2001a, so that heat generated by the electronic components disposed on the first surface 2001a is transferred to the first heat dissipating portion 110 by using the thermally conductive member 30. The thermally conductive member 30 may alternatively be disposed between the second heat dissipating portion 206a and the electronic components on the second surface 2002a. The thermally conductive member 30 is in contact with or is connected to the electronic components disposed on the second surface 2002a, so that heat generated by the electronic components disposed on the second surface 2002a is transferred to the second heat dissipating portion 206a by using the thermally conductive member 30.

In addition to dissipating heat generated by the circuit board 200a, the thermally conductive member 30 may further tightly bond the first shielding member 10 and/or the second shielding member 20a and the circuit board 200 together. The thermally conductive member 30 may be thermally conductive adhesive or thermally conductive foam. The thermally conductive member 30 may include macromolecular thermally-conductive material or other suitable material such as silica gel and rubber.

It may be understood that in different implementations, the first heat dissipating portion 110 and/or the second heat dissipating portion 206a are/is separately in direct contact with the electronic components disposed on the first surface 2001a and/or the second surface 2002a. Alternatively, the first heat dissipating portion 110 and/or the second heat dissipating portion 206a are separately connected to the electronic components disposed on the first surface 2001a and/or the second surface 2002a by using the thermally conductive member 30.

It may be understood that in some embodiments, to perform heat dissipation more effectively, a heat dissipating strip may be disposed on the second shielding member 20a, to increase an amount of dissipated heat.

The second shielding member 20a is integrally molded. Specifically, the second bottom wall 202a, the second side wall 204a and the second heat dissipating portion 206a are an integrated structure. The second bottom wall 202a, the second side wall 204a and the second heat dissipating portion 206a may be set to the integrated structure in any suitable manner, such as integrated casting, stamping, or another suitable manner. To further ensure sealing, one end of the second heat dissipating portion 206a is in contact with the circuit board 200.

It may be understood that in some other embodiments, the second heat dissipating portion 206a and the second bottom wall 202a and the second side wall 204a may alternatively be separate structures. The second heat dissipating portion 206a may be mounted on the second bottom wall 202a and the second side wall 204a. For example, the second heat dissipating portion 206a is welded on the second bottom wall 202a and the second side wall 204a. In addition, to ensure sealing, the second heat dissipating portion 206a is snugly mounted on the second bottom wall 202a and the second side wall 204a.

It may be understood that in some other embodiments, the antenna interface hole 113, the adjustment hole 114 and the data interface 115 may alternatively be disposed on the second shielding member 20a. Alternatively, some of the antenna interface hole 113, the adjustment hole 114 and the data interface 115 is/are provided on the first shielding member 10, and the other are/is provided on the second shielding member 20a. For example, the antenna interface hole 113 is disposed on the first shielding member 10, and the adjustment hole 114 and the data interface 115 are disposed on the second shielding member 20a.

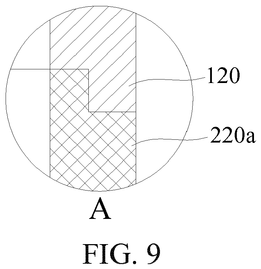

Referring to FIG. 9, FIG. 9 is a locally enlarged diagram of a junction A between the first shielding member 10a and the second shielding member 20a. The first shielding member 10 is connected to the second shielding member 20a in a snap-fit manner. Specifically, an outer side wall of the second shielding member 20a is provided with a gap 220a. The first shielding member 10 is provided with a protrusion 120. The protrusion 120 may be embedded in the gap 220a, so that the second shielding member 20a is positioned and mounted on the first shielding member 10, and sealing can be further ensured. It may be understood that in some other embodiments, an outer side wall of the first shielding member 10 may be provided with a gap, and the second shielding member 20a may be provided with a protrusion.

It may be understood that in some embodiments, an inner wall of the first shielding member 10 or the second shielding member 20a is provided with a groove, and the circuit board 200a is inserted in the groove to be fixed inside the electromagnetic shielding structure 300.

In the electromagnetic shielding structure 300 provided in the another embodiment of the present application, the first shielding member 10 accommodates the electronic components disposed on the first surface 2001a; the second shielding member 20a accommodates the electronic components disposed on the second surface 2002a, so that the electromagnetic shielding structure 300 may effectively perform shielding and heat dissipation for the circuit board 200a.

In addition, the first shielding member 10 includes the at least two first accommodating cavities 1120 independent of each other. The electronic components disposed on the first surface 2001a are separately accommodated in the first accommodating cavities 1120 independent of each other. The second shielding member 20a includes the at least two second accommodating cavities 2120a independent of each other. The electronic components disposed on the second surface 2001a are separately accommodated in the second accommodating cavities 2120a independent of each other, so that electromagnetic interference generated between the electronic components of the circuit board 200a may be reduced.

Still another embodiment of the present application provides an electronic device. The electronic device includes the electromagnetic shielding structure 100 and the circuit board 200. The first shielding member 10 and the second shielding member 20 jointly accommodate and seal the circuit board 200 between the first shielding member 10 and the second shielding member 20. Alternatively, the electronic device includes the electromagnetic shielding structure 300 and the circuit board 200a. The first shielding member 10 and the second shielding member 20a jointly accommodate and seal the circuit board 200a between the first shielding member 10 and the second shielding member 20a.

It should also be finally noted that, the foregoing embodiments are merely intended for describing the technical solutions of the present application rather than limiting the present application. According to the idea of the present application, technical features in the foregoing embodiments or different embodiments may also be combined, steps may be implemented in any sequence, and there may be many other variations of the present application in different aspects as described above. For brevity, the variations are not provided in detail. Although the present application is described in detail with reference to the foregoing embodiments, persons of ordinary skill in the art should understand that they may still make modifications to the technical solutions described in the foregoing embodiments or make equivalent replacements for some technical features in the technical solutions, and the essence of corresponding technical solutions does not depart from the scope of the technical solutions in the embodiments of the present application in spite of these modifications or replacements.

## Claims

1. An electromagnetic shielding structure (100, 300) applied to a circuit board (200, 200a), comprising:
a first shielding member (10), wherein the first shielding member (10)comprises a first bottom wall (102) and a first side wall (104) extending from an outer edge of the first bottom wall (102), wherein the first bottom wall (102) and the first side wall (104) of the first shielding member (10) form a first cavity (112), and wherein the first shielding member (10) comprises a first cavity partition wall (106), and the first cavity partition wall (106) partitions the first cavity (112) into at least two first accommodating cavities (1120); and
a second shielding member (20, 20a), detachably mounted on the first shielding member (10), so as to seal the first cavity (112) of the first shielding member (10), wherein
the first shielding member (10) and the second shielding member (20, 20a) jointly accommodate the circuit board (200, 200a) between the first shielding member (10) and the second shielding member (20, 20a), to perform electromagnetic shielding for the circuit board (200, 200a).

2. The electromagnetic shielding structure (100, 300) according to claim 1, wherein one end of the first cavity partition wall (106) is in contact with the circuit board (200) or is connected to the circuit board (200).

3. The electromagnetic shielding structure (100) according to claim 2, wherein the first cavity partition wall (106) further comprises a first sealing rubber strip disposed on an end face of the first cavity partition wall (106), wherein the first sealing rubber strip is in contact with the circuit board (200) or is connected to the circuit board (200), so as to seal the at least two first accommodating cavities (1120).

4. The electromagnetic shielding structure (100) according to any of claims 1 to 3, wherein electronic components are disposed on the circuit board (200), the circuit board (200) comprises a first surface (2001) and second surface (2002) that are oppositely disposed, and the electronic components are all disposed on the first surface (2001); the second shielding member (20) is of a flat-plate shape, the first surface (2001) faces toward the first cavity (112) of the first shielding member (10), the second surface (2002) faces toward the second shielding member (20), and the entire surface of the second surface (2002) is in contact with the second shielding member (20).

5. The electromagnetic shielding structure (100) according to claim 4, wherein a first heat dissipating portion (110) is disposed on the first shielding member (10), wherein the electronic components disposed on the first surface (2001) perform heat dissipation by using the first heat dissipating portion (110).

6. The electromagnetic shielding structure (100) according to claim 5, wherein the first heat dissipating portion (110) is in contact with or is connected to the electronic components disposed on the first surface (2001).

7. The electromagnetic shielding structure (100) according to claim 5 or 6, wherein a thermally conductive member (30) is disposed between the first heat dissipating portion (110) and the electronic components disposed on the first surface (2001), and the thermally conductive member (30) is in contact with or is connected to the electronic components disposed on the first surface (2001), so that heat generated by the electronic components disposed on the first surface (2001) is transferred to the first heat dissipating portion (110) by using the thermally conductive member (30).

8. The electromagnetic shielding structure (100) according to claim 7, wherein the thermally conductive member (30) is thermally conductive adhesive or thermally conductive foam.

9. The electromagnetic shielding structure (300) according to any of claims 1 to 3, wherein electronic components are disposed on the circuit board (200a), the circuit board (200a) comprises a first surface (2001a) and a second surface (2002a) that are oppositely disposed, and the electronic components are separately disposed on the first surface (2001a) and the second surface (2002a); the second shielding member (20a) comprises a second bottom wall (202a) and a second side wall (204a) extending from an outer edge of the second bottom wall (202a), the second bottom wall (202a) and the second side wall (204a) form a second cavity (212a), the first surface (2001a) faces toward the first cavity (112) and the second surface (2002a) faces toward the second cavity (212a).

10. The electromagnetic shielding structure (300) according to claim 9, wherein the second shielding member (20a) comprises a second cavity partition wall, wherein the second cavity partition wall partitions the second cavity (212a) into at least two second accommodating cavities (2120a), wherein one end of the second cavity partition wall is in contact with the second surface (2002a) or is connected to the second surface (2002a).

11. The electromagnetic shielding structure (300) according to claim 10, wherein the second cavity partition wall further comprises a second sealing rubber strip disposed on an end face of the second cavity partition wall, wherein the second sealing rubber strip is in contact with the second surface (2002a) or is connected to the second surface (2002a), so as to seal the at least two second accommodating cavities (2120a).

12. The electromagnetic shielding structure (300) according to any of claims 9 to 11, wherein a first heat dissipating portion (110) is disposed on the first shielding member (10), wherein the electronic components disposed on the first surface (2001a) perform heat dissipation by using the first heat dissipating portion (110); and a second heat dissipating portion (206a) is disposed on the second shielding member (20a), wherein the electronic components disposed on the second surface (2002a) perform heat dissipation by using the second heat dissipating portion (206a).

13. The electromagnetic shielding structure (300) according to claim 12, wherein the first heat dissipating portion (110) is in contact with or is connected to the electronic components disposed on the first surface (2001a), and/or the second heat dissipating portion (206a) is in contact with or is connected to the electronic components disposed on the second surface (2002a).

14. The electromagnetic shielding structure (300) according to claim 12 or 13, wherein a thermally conductive member (30) is disposed between the first heat dissipating portion (110) and the electronic components, wherein the thermally conductive member (30) is in contact with or is connected to the electronic components disposed on the first surface (2001a), so that heat generated by the electronic components disposed on the first surface (2001a) is transferred to the first heat dissipating portion (110) by using the thermally conductive member (30).

15. The electromagnetic shielding structure (300) according to claim 14, wherein a thermally conductive member (30) is disposed between the second heat dissipating portion (206a) and the electronic components, wherein the thermally conductive member (30) is in contact with or is connected to the electronic components disposed on the second surface (2002a), so that heat generated by the electronic components disposed on the second surface (2002a) is transferred to the second heat dissipating portion (206a) by using the thermally conductive member (30).

16. The electromagnetic shielding structure (300) according to claim 14 or 15, wherein the thermally conductive member (30) is thermally conductive adhesive or thermally conductive foam.

17. The electromagnetic shielding structure (100, 300) according to any of claims 1 to 16, wherein the circuit board (200a) comprises two circuit boards that are disposed in parallel, wherein the first surface (2001, 2001a) is located on one of the circuit boards, and the second surface (2002, 2002a) is located on the other of the circuit boards.

18. The electromagnetic shielding structure (100, 300) according to any of claims 1 to 17, wherein the first shielding member (10) and/or the second shielding member (20, 20a) are/is provided with heat dissipating strips/a heat dissipating strip.

19. The electromagnetic shielding structure (100, 300) according to any of claims 1 to 18, wherein the first shielding member (10) and the second shielding member (20, 20a) are connected in a snap-fit manner.

20. The electromagnetic shielding structure (300) according to claim 19, wherein one of the first shielding member (10) and the second shielding member (20a) comprises a protrusion, and the other comprises a gap, wherein the protrusion is inserted in the gap.

21. The electromagnetic shielding structure (100, 300) according to any of claims 1 to 20, wherein an inner wall of the first shielding member (10) or the second shielding member (20, 20a) is provided with a groove, and the circuit board (200, 200a) is inserted in the groove to be fixed inside the electromagnetic shielding structure (100, 300).

22. The electromagnetic shielding structure (100, 300) according to any of claims 1 to 20, wherein the circuit board (200, 200a) is provided with a plurality of first through holes (2003), and the first shielding member (10) and/or the second shielding member (20, 20a) are/is provided with a plurality of second through holes (203) whose position distribution and number are in one-to-one correspondence with those of the first through holes (2003), and wherein the first through holes (2003) and the second through holes (203) are configured to mount the circuit board (200, 200a) in the electromagnetic shielding structure (100, 300).

23. The electromagnetic shielding structure (100, 300) according to any of claims 1 to 22, wherein the first shielding member (10) and/or the second shielding member (20, 20a) are/is integrally molded.

24. An electronic device, comprising a circuit board (200, 200a) and the electromagnetic shielding structure (100, 300) according to any of claims 1 to 23, wherein the first shielding member (10) and the second shielding member (20, 20a) jointly accommodate the circuit board (200, 200a) between the first shielding member (10) and the second shielding member (20, 20a).
